# EUROPEAN PATENT APPLICATION

(11) **EP 4 618 157 A1**
(43) Date of publication of application: **17.09.2025**
(21) Application number: 24162661.3
(22) Date of filing: 11.03.2024
(51) Int. Cl.: H01L 29/417, H01L 29/423, H01L 29/66, H01L 29/786

(54) **TRANSISTOR DEVICE AND METHOD**

(71) Applicant: Huawei Technologies Co., Ltd., Shenzhen, Guangdong 518129 (CN)
(72) Inventor: SANG, Xia, 80992 Munich (DE); LEONELLI, Daniele, 80992 Munich (DE); LI, Wei, 80992 Munich (DE); JIN, Ming, 80992 Munich (DE)
(74) Representative: Roth, Sebastian

(57) **Abstract**

A transistor device is provided, comprising one or more base layers, a semiconductor layer arranged on the one or more base layers, a source structure arranged on the semiconductor layer, a drain structure arranged on the semiconductor layer, and a gate structure arranged on the semiconductor layer between the source and drain structures. The gate structure comprises a dielectric layer arranged on the semiconductor layer, a gate metal layer arranged on the dielectric layer to cover a portion of the dielectric layer, and a capping layer comprising a first portion arranged on the dielectric layer between the source structure and the gate metal layer, and a second portion arranged on the dielectric layer between the gate metal layer and the drain structure. The gate metal layer is higher than the capping layer and is also higher than the dielectric layer.

## Description

### TECHNICAL FIELD

The present disclosure relates to a transistor device with raised source and drain electrodes. The disclosure also relates to a method for fabricating the transistor device.

### BACKGROUND

A field effect transistor (FET) comprises a channel arranged between source and drain contacts, and a gate contact that is arranged in close proximity to the channel. An electric field applied on the gate contact controls the flow of a current in the channel. A thin-film-transistor (TFT) is a special type of FET made by depositing thin films, e.g., semiconductor layers, dielectric layers and metallic contacts, on non-conducting substrates.

Indium gallium zinc oxide (InGaZnO or IGZO) is an oxide semiconductor material that can be used for the channel of a TFT. IGZO-based TFTs are promising candidates for implementing embedded dynamic random-access memories (eDRAMs) and three-dimensional (3D) DRAM applications due to its low leakage current and low processing temperature.

Amorphous IGZO (a-IGZO) has high contact resistance to metals. Therefore, when a-IGZO is used as a channel layer in FETs, other oxide semiconductors are often required as contact layers for source/drain electrodes. Such oxide semiconductors include, for example, indium tin oxide (ITO) or c-axis aligned crystalline IGZO (CAAC-IGZO).

Raised source/drain (RSD) structures have been proposed as an optimization approach in TFTs that enable to disperse the drain electric field, thereby also reducing the leakage current.

The adaptation of RSD structures in oxide semiconductor devices is currently not well-developed. In conventional RSD structures on oxide semiconductor devices, CAAC-IGZO is deposited on top of an a-IGZO layer, and subsequently etched at the gate opening. The remaining CAAC-IGZO at the source and drain serves as the raised contact. The etched gate opening is subsequently filled with a gate oxide material, a barrier layer and a metal.

In these conventional devices, a timed etch process is used to etch through the CAAC-IGZO and lands on a-IGZO. However, since CAAC-IGZO and a-IGZO have identical chemical composition, the etch selectivity between the two materials is extremely low, resulting in a poorly controlled etch landing process. The thickness of the remaining a-IGZO, thus, can only be estimated, and over-etching is difficult to avoid. Additionally, etch-induced damage at the a-IGZO surface hinders the gate control and leads to deteriorated mobility and reliability.

### SUMMARY

In view of the above, this disclosure aims to provide an improved structure for a FET device. An objective is to provide a FET that avoids over-etching the channel layer.

These and other objectives are achieved by this disclosure as described in the independent claims. Advantageous implementations are described in the dependent claims.

A first aspect of this disclosure provides a transistor device comprising one or more base layers, a semiconductor layer arranged on the one or more base layers, a source structure arranged on the semiconductor layer, a drain structure arranged on the semiconductor layer, and a gate structure arranged on the semiconductor layer between the source structure and the drain structure. The gate structure comprises a dielectric layer arranged on the semiconductor layer, a gate metal layer arranged on the dielectric layer to cover a portion of the dielectric layer, and a capping layer. The capping layer comprises a first portion and a second portion, the first portion being arranged on the dielectric layer between the source structure and the gate metal layer, and the second portion being arranged on the dielectric layer between the gate metal layer and the drain structure, wherein a height of the capping layer and a height of the dielectric layer are respectively smaller than a height of the gate metal layer.

The semiconductor layer comprises, for example, an oxide semiconductor material, and acts as the channel (or channel layer) in the transistor device. The oxide semiconductor material may comprise a-IGZO.

In this disclosure, the terms "semiconductor layer" and "channel" or "channel layer" may be used interchangeably.

The capping layer may comprise, for example, a nitride material.

The dielectric layer may comprise, or may be made of, for example hafnium dioxide (HfO₂), or aluminum oxide (Al₂O₃), or silicon dioxide (SiO₂).

The gate metal layer may comprise tungsten (W) or another metal.

The height of the capping layer is the height of the capping layer from a surface of the dielectric layer. In other words, the height of the capping layer is a dimension of the capping layer extending away from the dielectric layer in a first direction, as it will be explained later on in this disclosure.

The height of the dielectric layer is the height of the dielectric layer from a surface of the semiconductor layer. In other words, the height of the dielectric layer is a dimension of the dielectric layer extending away from the semiconductor layer in the first direction.

The height of the gate metal layer is the height of the gate metal layer from a surface of the dielectric layer. In other words, the height of the gate metal layer is a dimension of the gate metal layer extending away from the dielectric layer in the first direction.

Depending on the conditions of forming the transistor device (i.e. the growth conditions), a layer/structure provided on or above another layer/structure may cover any exposed surface of the structure/layer below only partly or completely. Also, a thickness or height of the layer/structure on the surface of the structure/layer below it can be controlled, particularly relative to the thickness or height of the layer/structure on the other surfaces of the structure/layer beneath it.

In this document, the terms "upwards", "on", "top", "above" etc. relate to the terms "downwards", "bottom", "below" etc., according to a fabrication direction, e.g. by epitaxial growth, of the transistor device. That is, the "lowest" point of the transistor device is on the one or more base layers. Thus, the semiconductor layer, the source structure, the drain structure, the gate structure and its different layers extend "upwards" from the one or more base layers. Accordingly, the first direction disclosed above may be the growing direction of the transistor device.

The transistor device of the first aspect allows to avoid over-etching of the channel layer during the fabrication of the gate opening by using the capping layer on top of the gate dielectric layer. That is, the capping layer and the gate dielectric layer can act as an etch stop layer (ESL). Thereby, etch-induced damage on the channel surface is strongly reduced, which enables to control the thickness (or height) of the channel, and further leads to an optimized channel-gate dielectric interface quality.

Further, since the height of the gate metal layer is larger than the height of the dielectric layer and is also larger than the height of the capping layer, the dielectric layer has a planar shape, i.e., there is no dielectric on side surfaces of the gate metal layer (referred to as having an U-shape) as in conventional devices, and there is no capping layer on side surfaces of the gate metal layer. This reduces the manufacture costs of the transistor device, and further improves the quality of the channel-gate dielectric interface.

Further, due to the higher etch selectivity of the capping layer compared to the oxide semiconductor layer, the source and drain are provided directly on top of the channel layer. This eliminates the need to add other oxide materials between the source/drain contacts and the channel. Thereby, the contact between the source and drain electrodes with the channel can be enhanced in a simplified manner.

In an implementation form of the first aspect, the gate structure further comprises a first barrier layer provided on side surfaces of the gate metal layer and between the gate metal layer and the dielectric layer.

This provides the advantage of protecting the gate metal layer.

In an implementation form of the first aspect, the semiconductor layer comprises a metal oxide semiconductor, wherein the metal oxide semiconductor comprises a-IGZO.

In an implementation form of the first aspect, a height of the source structure and a height of the drain structure are respectively larger than a height of the semiconductor layer.

The height of the source structure is the height of the source structure from the surface of the semiconductor layer. That is, the height of the source structure is a dimension of the gate metal layer extending away from the semiconductor layer in the first direction.

The height of the drain structure is the height of the drain structure from the surface of the semiconductor layer. That is, the height of the drain structure is a dimension of the gate metal layer extending away from the semiconductor layer in the first direction.

The height of the source structure and the height of the drain structure can be equal to each other or can be different.

Thus, a RSD structure can be implemented in a simplified manner.

In an implementation form of the first aspect, the source structure comprises a first metal electrode arranged on the semiconductor layer.

The first metal electrode may comprise, or may be made of, W or another metal.

In an implementation form of the first aspect, the source structure further comprises a first material layer provided on side surfaces of the first metal electrode and between the first metal electrode and the semiconductor layer.

This provides a conductive path from the source electrode to the semiconductor (channel) layer.

In an implementation form of the first aspect, the source structure further comprises a second barrier layer provided on side surfaces of the first material layer.

This provides the advantage of protecting the first metal electrode and the first material layer.

Further, the source electrode has an U-shape.

In an implementation form of the first aspect, the drain structure comprises a second metal electrode arranged on the semiconductor layer.

The second metal electrode may comprise, or may be made of, W or another metal.

In an implementation form of the first aspect, the drain structure further comprises a second material layer provided on side surfaces of the second metal electrode and between the second metal electrode and the semiconductor layer.

This provides a conductive path from the semiconductor (channel) layer to the drain electrode.

In an implementation form of the first aspect, the drain structure further comprises a third barrier layer provided on side surfaces of the second material layer.

This provides the advantage of protecting the second metal electrode and the second material layer.

Further, the drain electrode has an U-shape.

In an implementation form of the first aspect, the first material layer may comprise an oxide semiconductor material, for example ITO.

The second material layer may comprise an oxide semiconductor material, for example ITO.

The first material layer and the second material layer may comprise, or may be made of, a same oxide semiconductor material. Alternatively, first material layer and the second material layer may comprise, or may be made of, different oxide semiconductor materials.

In an implementation form of the first aspect, the second barrier layer may comprise, or may be made of, a material that can protect the first metal electrode and the first material layer. For example, the second barrier layer may comprise titanium nitride (TiN).

The third barrier layer may comprise, or may be made of, a material that can protect the second metal electrode and the second material layer. For example, the third barrier layer may comprise TiN.

The second barrier layer and the third barrier layer may comprise, or may be made of, the same material. Alternatively, the second barrier layer and the third barrier layer may comprise, or may be made of, different materials.

In an implementation form of the first aspect, the first barrier layer may comprise, or may be made of, a material that can protect the gate metal layer. For example, the first barrier layer may comprise, or may be made of, TiN.

In an implementation form of the first aspect, the one or more base layers comprise a substrate, and one or more material layers arranged above the substrate

For example, the one or more base layers may comprise the substrate and an oxygen tunnel. The oxygen tunnel may comprise an oxygen passing layer arranged above the substrate and below the semiconductor (channel) layer, and an oxygen blocking layer arranged above the substrate and below the semiconductor (channel) layer, and next to the oxygen passing layer. Further, the oxygen tunnel may also comprise a second dielectric layer arranged above the substrate and below the oxygen passing layer and the at least one oxygen blocking layer.

By using the oxygen tunnel, the electrical properties of the a-IGZO channel layer can be controlled. For example, a desired concentration of oxygen dopants in the a-IGZO layer can be adjusted to compensate or repair damages or defects in the channel layer that may occur during fabrication of the transistor device.

A second aspect of this disclosure provides a method for fabricating a transistor device. The method comprises: providing one or more base layers; forming a semiconductor layer on the one or more base layers; forming a source structure on the semiconductor layer; forming a drain structure on the semiconductor layer; and forming a gate structure on the semiconductor layer between the source structure and the drain structure. The gate structure is formed by: forming a dielectric layer on the semiconductor layer; forming a gate metal layer on the dielectric layer to cover a portion of the dielectric layer; forming a capping layer comprising a first portion and a second portion, the first portion being formed on the dielectric layer between the source structure and the gate metal layer, and the second portion being formed on the dielectric layer between the gate metal layer and the drain structure, wherein a height of the capping layer and a height of the dielectric layer are respectively smaller than a height of the gate metal layer.

In an implementation form of the second aspect, forming the gate structure further comprises forming a first barrier layer on side surfaces of the gate metal layer and between the gate metal layer and the dielectric layer.

This provides the advantage of protecting the gate metal layer.

In an implementation form of the second aspect, the semiconductor layer comprises a metal oxide semiconductor, and the metal oxide semiconductor comprises a-IGZO.

In an implementation form of the second aspect, a height of the source structure and a height of the drain structure are respectively larger than a height of the semiconductor layer.

In other words, a RSD structure can be implemented in a simplified manner.

In an implementation form of the second aspect, forming the source structure comprises forming a first metal electrode on the semiconductor layer.

The first metal electrode may comprise, or may be made of, W or another metal.

In an implementation form of the second aspect, forming the source structure further comprises forming a first material layer on side surfaces of the first metal electrode and between the first metal electrode and the semiconductor layer.

This provides a conductive path from the source electrode to the semiconductor (channel) layer.

In an implementation form of the second aspect, forming the source structure further comprises forming a second barrier layer provided on side surfaces of the first material layer.

This provides the advantage of protecting the first metal electrode and the first material layer.

Further, the source electrode has an U-shape.

In an implementation form of the second aspect, forming the drain structure comprises forming a second metal electrode arranged on the semiconductor layer.

The second metal electrode may comprise, or may be made of, W or another metal.

In an implementation form of the second aspect, forming the drain structure further comprises forming a second material layer on side surfaces of the second metal electrode and between the second metal electrode and the semiconductor layer.

This provides a conductive path from the semiconductor (channel) layer to the drain electrode.

In an implementation form of the second aspect, forming the drain structure further comprises forming a third barrier layer on side surfaces of the second material layer.

This provides the advantage of protecting the second metal electrode and the second material layer.

Further, the drain electrode has an U-shape.

In an implementation form of the second aspect, the first material layer may comprise an oxide semiconductor material, for example ITO.

The second material layer may comprise an oxide semiconductor material, for example ITO.

The first material layer and the second material layer may comprise, or may be made of, a same oxide semiconductor material. Alternatively, first material layer and the second material layer may comprise, or may be made of, different oxide semiconductor materials.

In an implementation form of the second aspect, the second barrier layer may comprise, or may be made of, a material that can protect the first metal electrode and the first material layer. For example, the second barrier layer may comprise titanium nitride TiN.

The third barrier layer may comprise, or may be made of, a material that can protect the second metal electrode and the second material layer. For example, the third barrier layer may comprise TiN.

The second barrier layer and the third barrier layer may comprise, or may be made of, a same material. Alternatively, the second barrier layer and the third barrier layer may comprise, or may be made of, different materials.

In an implementation form of the second aspect, the first barrier layer may comprise, or may be made of, a material that can protect the gate metal layer. For example, the first barrier layer may comprise, or may be made of, TiN.

In an implementation form of the second aspect, providing the one or more base layers comprises providing a substrate, and providing one or more material layers arranged above the substrate

For example, the one or more base layers may comprise the substrate and an oxygen tunnel. The oxygen tunnel may comprise an oxygen passing layer arranged above the substrate and below the semiconductor (channel) layer, and at least one oxygen blocking layer arranged above the substrate and below the semiconductor (channel) layer, and next to the oxygen passing layer. Further, the oxygen tunnel may also comprise a second dielectric layer arranged above the substrate and below the oxygen passing layer and the at least one oxygen blocking layer.

By using the oxygen tunnel, the electrical properties of the a-IGZO channel layer can be controlled. For example, a desired concentration of oxygen dopants in the a-IGZO layer can be adjusted to compensate or repair damages or defects in the channel layer that may occur during fabrication of the transistor device.

The method of the second aspect may have implementation forms, which correspond to the transistor device of the first aspect, that is, the method may produce each implementation form of the transistor device.

### BRIEF DESCRIPTION OF DRAWINGS

The above described aspects and implementation forms will be explained in the following description of specific embodiments in relation to the enclosed drawings, in which;
- FIG. 1: schematically depicts a cross-section of a transistor device according to this disclosure.
- FIG. 2: schematically depicts a cross-section of a transistor device according to this disclosure.
- FIG. 3: schematically depicts a cross-section of a transistor device according to this disclosure.
- FIG. 4: shows a method according to this disclosure for fabricating a transistor device.
- FIG. 5A-5L: schematically depict an example for fabricating a transistor device according to this disclosure.

In the figures, same elements are labeled with the same reference signs, and may be implemented likewise. The size of elements in the figures is not to scale and may be different compared to a real life implementation in order to highlight details of the embodiments.

### DETAILED DESCRIPTION OF EMBODIMENTS

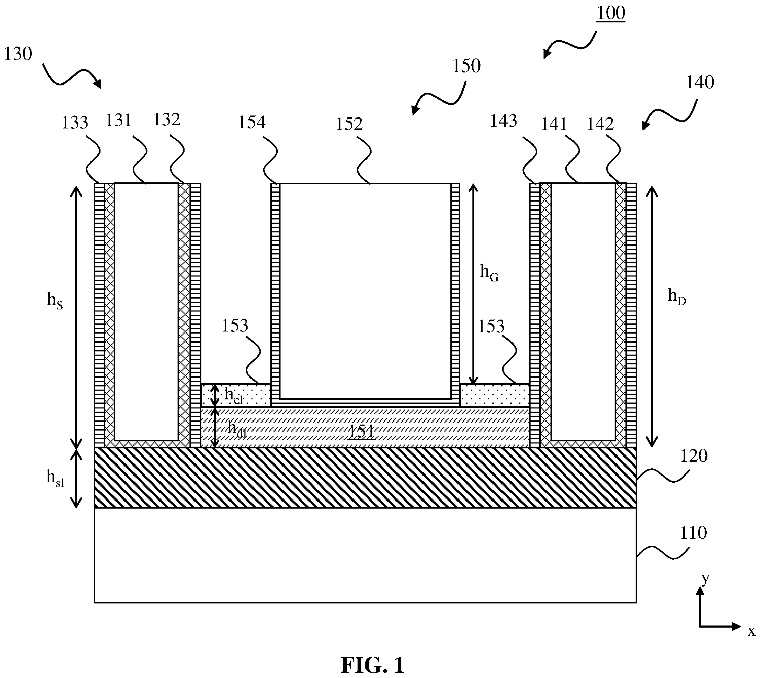

FIG. 1 shows a cross-section of an exemplary embodiment of a transistor device 100 according to this disclosure.

The transistor device 100 can be a portion or section of a FET device or can form the entire FET device. The FET device may be a TFT.

The transistor device 100 comprises one or more base layers 110. The one or more base layers 110 may comprise a substrate.

The transistor device 100 further comprises a semiconductor layer 120 arranged on top of the one or more base layers 110. The semiconductor layer 120 comprises a metal oxide semiconductor material, for example IGZO, in particular a-IGZO.

Further, the transistor device 100 comprises a source structure 130 arranged on top of the semiconductor layer 120, and a drain structure 140 arranged on top of the semiconductor layer 120. The source and drain structures 120, 130 are formed on two opposite sides of the semiconductor layer 120. Thus, the semiconductor layer 120 may form a FET channel between the source and drain structures 120, 130.

In this disclosure, the terms "upwards", "on", "top", "on top", "above" etc., relate to the terms "downwards", "bottom", "below" etc., according to the fabrication direction (e.g. by epitaxial growth) of the transistor device 100. That is, the "lowest" point of the transistor device 100 is on the one or more base layers 110, and the structures and layers explained in the disclosure extend "upwards" from the one or more base layers 110 along a first direction. Said first direction can be for example a y-direction as indicated by the reference coordinate system depicted in FIG. 1.

Further, depending on the conditions of forming the transistor device 100 (i.e. the growth conditions), a layer/structure provided on top of another layer/structure may cover any exposed surface of the structure/layer below only partly or completely. Also, a thickness or height of the layer/structure on the surface of the structure/layer below it can be controlled, particularly relative to the thickness or height of the layer/structure on the other surfaces of the structure/layer beneath it. In this disclosure, the aforementioned first direction may be the growing direction of the transistor device 100.

Thus, in this exemplary embodiment, the semiconductor layer 120 extends along the first direction (i.e., the y-direction), and the source and drain structures 130, 140 extend from the semiconductor layer 120 along the first direction and are arranged on top of said semiconductor layer 120 next to each other and in two opposite sides along a second direction, the second direction being perpendicular to the first direction (i.e., the x-direction in the reference coordinate system of FIG. 1).

The transistor device 100 further comprises a gate structure 150 arranged above the semiconductor layer 120, between the source and drain structures 130, 140. That is, the gate structure 150 extends from the semiconductor layer 120 along the first direction, and the source 130, gate 150 and drain 140 structures are arranged next to each other in the second direction, with the gate structure 150 being located on a central, or substantially central, portion above said semiconductor layer 120.

The gate structure 150 comprises a dielectric layer 151 arranged directly on top of the semiconductor layer 120, and may be arranged between the source and drain structures 130, 140, i.e., the dielectric layer 151 extends from the semiconductor layer 120 along the first direction, and is located on top of the semiconductor layer 120 between the source and drain structures 130, 140, thereby covering a portion of the semiconductor layer 120 that is not covered by the source and drain structures 130, 140.

The dielectric layer 151 may comprise or may be made of, for example and not as a limitation, Al₂O₃, HfO₂, or silicon dioxide SiO₂.

Further, the gate structure 150 comprises a gate metal layer 152 arranged on top of the dielectric layer 151 to cover a portion of the dielectric layer 151. For example, the gate metal layer 152 may only cover a central or substantially central portion (in the second direction) of the dielectric layer 151, as depicted in FIG. 1.

The gate metal layer 152 may comprise or may be made of W, or another metal or alloy.

The gate structure 150 further comprises a capping layer 153 comprising a first portion and a second portion. The first portion of the capping layer 153 is arranged on top of the dielectric layer 151 between the source structure 130 and the gate metal layer 152. The second portion of the capping layer 153 is arranged on the dielectric layer 151 between the gate metal layer 152 and the drain structure 140.

That is, capping layer 153 extends from the dielectric layer 151 along the first direction, and is arranged on opposite sides of the gate metal layer 152 in the second direction, with the first and second portions being next to the source and drain structures 130, 140, respectively.

As depicted in FIG. 1, the first and second portions of the capping layer 153 may cover the portions of the dielectric layer 151 that are not covered by the gate metal layer 152.

The capping layer 153, i.e., each of its first and second portions, may comprise or may be made of, a nitride material.

Since the capping layer 153 and the semiconductor layer 120 are made of different materials, their etch selectivity is also different. The capping layer 153 may be selected to have a higher etch selectivity compared to the semiconductor layer 120.

The transistor device 100 of this exemplary embodiment avoids over-etching of the channel layer during the fabrication of the gate opening by using the capping layer 153 on top of the gate dielectric layer 151. That is, the capping layer 153 and the gate dielectric layer 151 can act as an ESL, thereby strongly reducing etch-induced damage on an upper surface of the channel layer 120 (in the y-direction). This enables to control the height (or thickness) hₛₗ of the channel layer, depicted with a vertical arrow in FIG. 1, and further leads to an optimized channel-gate dielectric interface quality.

The dielectric layer 151, the gate metal layer 152 and the capping layer 153 are formed so that a height h_{cl} of the capping layer 153 is smaller than a height h_{G} of the gate metal layer 152. At the same time, a height h_{dl} of the dielectric layer 151 is smaller than the height h_{G} of the gate metal layer 152.

The height h_{cl} of the capping layer 153 refers to its height from a surface of the dielectric layer 151. That is, the height h_{cl} of the capping layer is a dimension of the capping layer 153 extending away from the dielectric layer 151 in the first direction, i.e., in the y-direction.

The height h_{dl} of the dielectric layer 151 refers to its height from a surface of the semiconductor layer 120. In other words, the height h_{dl} of the dielectric layer 151 is a dimension of the dielectric layer 151 extending away from the semiconductor layer 120 in the first direction.

The height h_{G} of the gate metal layer 152 refers to its height from the surface of the dielectric layer 151. In other words, the height h_{G} of the gate metal layer 152 is a dimension of the gate metal layer 152 extending away from the dielectric layer 151 in the first direction.

The heights h_{dl}, h_{cl} and h_{G} are depicted with vertical arrows in FIG. 1.

Since in this disclosure the first direction corresponds to the growing direction of the transistor device 100, the height h_{dl} of the dielectric layer 151, the height h_{cl} of the capping layer 153, and the height h_{G} of the gate metal layer 152 can also be understood as being a thickness of the dielectric layer 151, a thickness of the capping layer 153, and a thickness of the gate metal layer 152, respectively.

Further, since the height h_{G} of the gate metal layer 152 is larger than the height h_{dl} of the dielectric layer 151 and is also larger than the height h_{cl} of the capping layer 153, the dielectric layer 151 has a planar shape, i.e., there is no dielectric material on side surfaces of the gate metal layer 152 (referred to as the gate metal layer has an U-shape) as in conventional devices. This reduces the manufacture costs of the transistor device 100, and further improves the quality of the channel-gate dielectric interface.

In the transistor device 100 according to FIG. 1, the gate structure 150 may further comprise a first barrier layer 154 provided on side surfaces of the gate metal layer 152 and between the gate metal layer 152 and the dielectric layer 151.

The first barrier layer 154 may comprise a material capable to protect the gate metal layer 152. For example, the first barrier layer may comprise, or may be made of, TiN.

In the transistor device 100 according to FIG. 1, the source structure 130 comprises a first metal electrode 131 arranged on top of the semiconductor layer 120. Additionally, the drain structure 140 comprises a second metal electrode 141 arranged on top of the semiconductor layer 120.

The first metal electrode 131 may comprise, or may be formed of, W or another metal, or an alloy. The second metal electrode 141 may comprise, or may be formed of, W or another metal, or an alloy. The first and second metal electrodes 131, 141 may comprise the same material or may be made of different materials.

The source and drain structures 130, 140 are formed so that a height hs of the source structure is larger than the height hₛₗ of the semiconductor layer 120. Additionally, a height h_{D} of the drain structure 140 is larger than the height hₛₗ of the semiconductor layer 120.

The height hs of the source structure 130 refers to its height from the surface of the semiconductor layer 120. That is, the height hs of the source structure 130 is a dimension of the source structure 130 extending away from the semiconductor layer 120 in the first direction (the y-direction).

The height h_{D} of the drain structure 140 refers to its height from the surface of the semiconductor layer 120. That is, the height h_{D} of the drain structure 140 is a dimension of the drain structure 140 extending away from the semiconductor layer 120 in the first direction (the y-direction).

The height hs of the source structure 130 and the height h_{D} of the drain structure 140, depicted with vertical arrows in FIG. 1, may be equal to each other, or may be different.

Thus, a RSD structure for the transistor device 100 can be implemented in a simplified manner.

Moreover due to the higher etch selectivity of the capping layer 153 compared to the semiconductor layer 120, the source and drain structures 130, 140 can be provided directly on top of the channel layer 120. This eliminates the need to add other oxide materials between the source/drain electrodes 131, 141 and the channel layer 120, as in conventional devices. Thereby, the contact between the source and drain electrodes 131, 141 with the channel layer 120 is enhanced in relatively easy manner.

The source and drain structures 130, 140 may further comprise a first material layer 132 and a second material layer 142, respectively.

The first material layer 132 may be provided on side surfaces of the first metal electrode 131 and between the first metal electrode 131 and the semiconductor layer 120. The second material layer 142 may be provided on side surfaces of the second metal electrode 141 and between the second metal electrode 141 and the semiconductor layer 120.

The first material layer 132, additionally or alternatively the second material layer 142, may each comprise, or may be made of, ITO or another material.

Thereby, a conductive path from the source electrode to the semiconductor (channel) layer 120 and a conductive path from the semiconductor (channel) layer 120 to the drain electrode, respectively, may be provided.

The source structure 130 may further comprise a second barrier layer 133 provided on side surfaces of the first material layer 132. For example, the second barrier layer 133 may comprise, or may be made of TiN.

Further, the drain structure 140 may comprise a third barrier layer 143 provided on side surfaces of the second material layer 142. For example, the third barrier layer 143 may comprise, or may be made of, TiN.

The second barrier layer 133 and the third barrier layer 143 may provide protection to the first metal electrode 131 and the first material layer 132, and to the second metal electrode 141 and the second material layer 142, respectively.

Notably, each of the source and drain electrodes 130, 140 has an U-shape, i.e., are conformally deposited U-shape contacts.

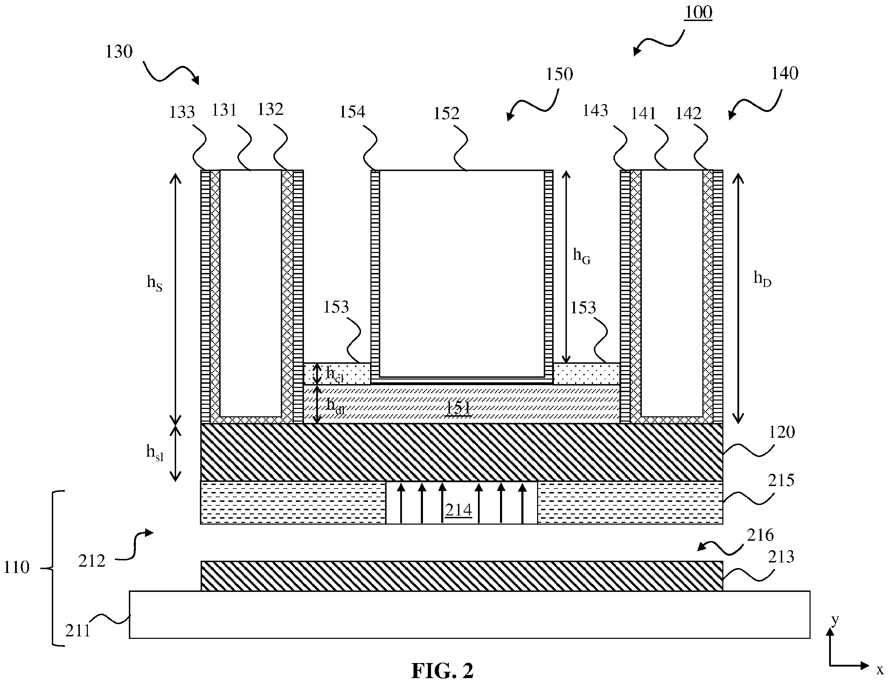

FIG. 2 shows an exemplary embodiment for a transistor device 100 according to this disclosure, which is based on the transistor device 100 shown in FIG. 1. Same elements in FIG. 1 and FIG. 2 are labelled with the same reference signs and are implemented likewise. Hereinafter only the differences between FIG. 1 and FIG. 2 are explained.

In the transistor device 100 according of FIG. 2, the one or more base layers 110 comprise a substrate 211 and one or more material layers 212 that are arranged above the substrate and below the semiconductor layer 120.

For example, as depicted in FIG. 2, the one or more material layers 212 may comprise a second semiconductor layer 213 arranged on top of the substrate 211, and an oxygen passing layer 214 arranged above the second semiconductor layer 213 and below the (first) semiconductor layer 120.

The one or more material layers 212 may further comprise an oxygen blocking layer 215 arranged next to the oxygen passing layer 214 and below the (first) semiconductor layer 120, and delimiting the oxygen passing layer 214 on two opposite sides.

The one or more material layers 212 may also comprise a gap above the second semiconductor layer 213 and below the an oxygen blocking layer 215 arranged next to the oxygen passing layer 214.

The second semiconductor layer 213 may comprise, or may be made of, a dielectric material, for example an oxide The second semiconductor layer 213 and the (first) semiconductor layer 120 may comprise the same or different materials.

The oxygen blocking layer 215 may comprise, or may be made of, a dielectric material, for example silicon dioxide or silicon nitride (SiN).

Thereby, in this exemplary embodiment, the one or more material layers 212 may implement and an oxygen tunnel. Such an oxygen tunnel, in particular the oxygen passing layer 214 forms an oxygen canal below the semiconductor channel layer 120 through which oxygen (O₂) can diffuse, as depicted with the vertical arrows in FIG. 2.

By using the oxygen tunnel, the electrical properties of the a-IGZO channel layer can be controlled. For example, a desired concentration of oxygen dopants in the a-IGZO layer can be adjusted to compensate or repair damages or defects in the channel layer that may occur during fabrication of the transistor device.

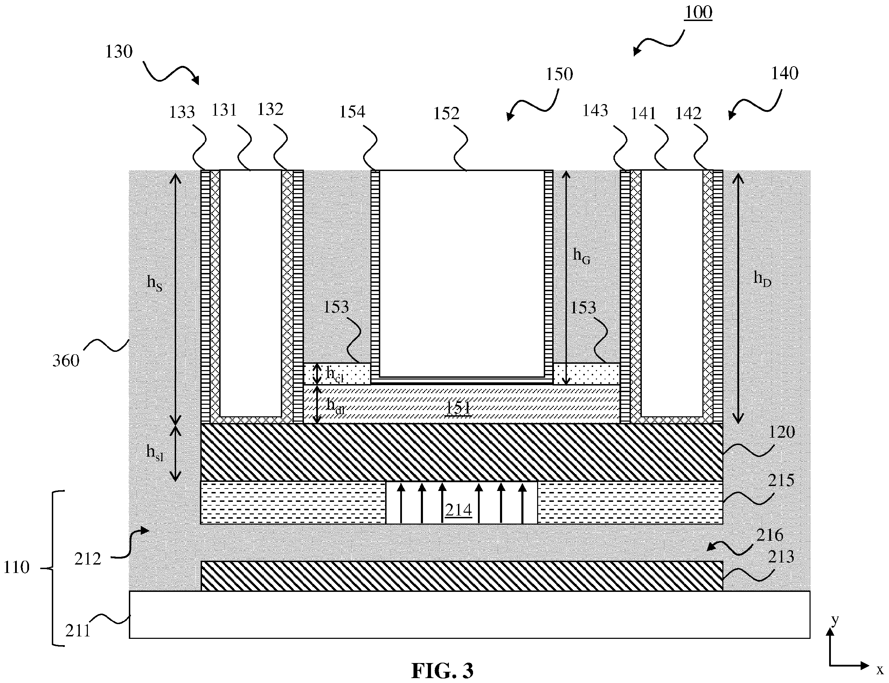

FIG. 3 shows another exemplary embodiment for a transistor device 100 according to this disclosure, which is based on the transistor device 100 shown in FIG. 2. Same elements in FIG. 2 and FIG. 3 are labelled with the same reference signs and are implemented likewise. Hereinafter only the differences between FIG. 2 and FIG. 3 are explained.

The transistor device 100 according of FIG. 3 may further comprise a third material layer 360 provided on side surfaces of the one or more base layers 110, of the semiconductor (channel) layer 120, of the source and drain structures 130, 140, and of the gate structure 150.

Additionally, the third material layer 360 may be provided on top surfaces of the source and drain structures 130, 140, of the capping layer 153, and of the gate structure 150.

When the one or more base layers 110 comprise the oxygen tunnel 212, the third material layer 360 may be further provided on side surfaces of the oxygen blocking layer 215 and of the second semiconductor layer 213. Further, the third material layer 360 may be provided filling the gap 216 between the second semiconductor layer 213 and the oxygen blocking layer 215 and the oxygen passing layer 214.

In other words, the third material layer 360 may be provided surrounding or substantially surrounding the transistor device 100 disclosed above in the exemplary embodiments of FIG. 2. Such a third material layer 360 is inherent to the fabrication process of the transistor device 100 and, thus, does not limit the advantages and functionality of the transistor device 100 of the exemplary embodiments according to FIG. 1 or FIG. 2.

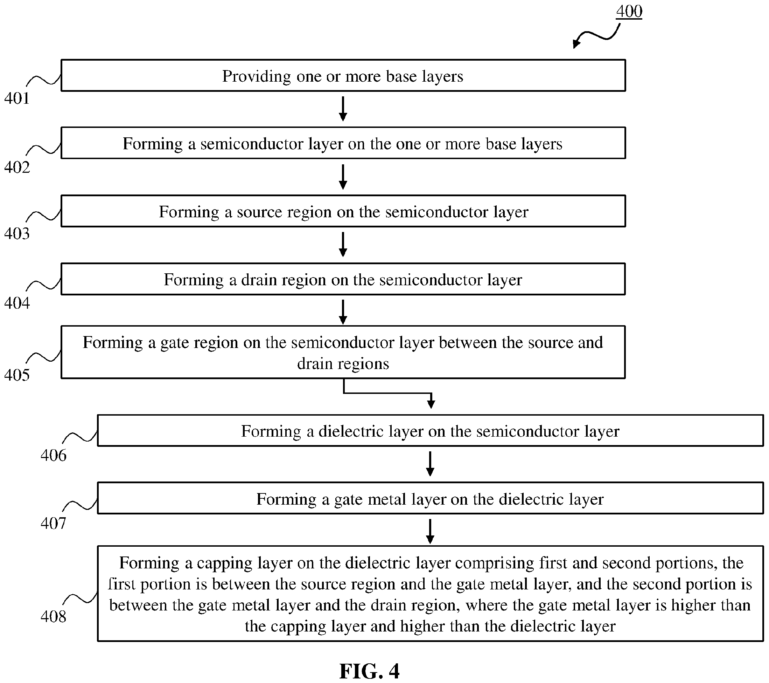

FIG. 4 shows steps of a method 400 according to this disclosure, which is suitable for fabricating any of the exemplary embodiments of the transistor device 100 described above and shown in FIG. 1, FIG. 2 and FIG. 3.

The method 400 comprises a step 401 of providing the one or more base layers 110.

Then, the method 400 comprises a step 402 of forming the semiconductor layer 120 on top of the one or more base layers 110.

Further, the method 400 comprises a step 403 of forming 403 the source structure 130 on the semiconductor layer 120, and a step 404 of forming 404 the drain structure 140 on the semiconductor layer 120.

The method 400 further comprises a step 405 of forming the gate structure 150 on the semiconductor layer 120 between the source structure 130 and the drain structure 140.

The step 405 may comprise a step 406 of forming the dielectric layer 151 on top of the semiconductor layer 120.

Further, the step 405 may comprise, a step 407 of forming the gate metal layer 152 on the dielectric layer 151 to cover a portion of the dielectric layer 151.

Then, the step 405 may comprise a step 408 of forming the capping layer 153 comprising the first portion and the second portion, the first portion being on the dielectric layer 151 between the source structure 130 and the gate metal layer 152, and the second portion being on the dielectric layer 151 between the gate metal layer 152 and the drain structure 140, wherein the height h_{G} of the gate metal layer 152 is larger than the height h_{cl} of the capping layer 153, and the height h_{G} of the gate metal layer 152 is also larger than the height h_{dl} of the dielectric layer 151, i.e., h_{G} > h_{cl} and h_{G} > h_{dl}.

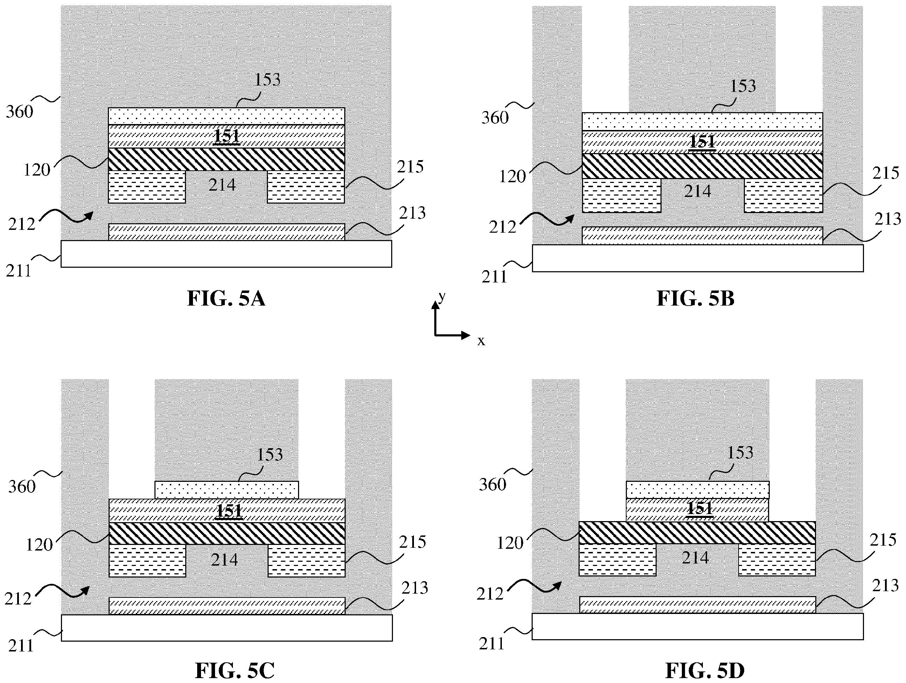

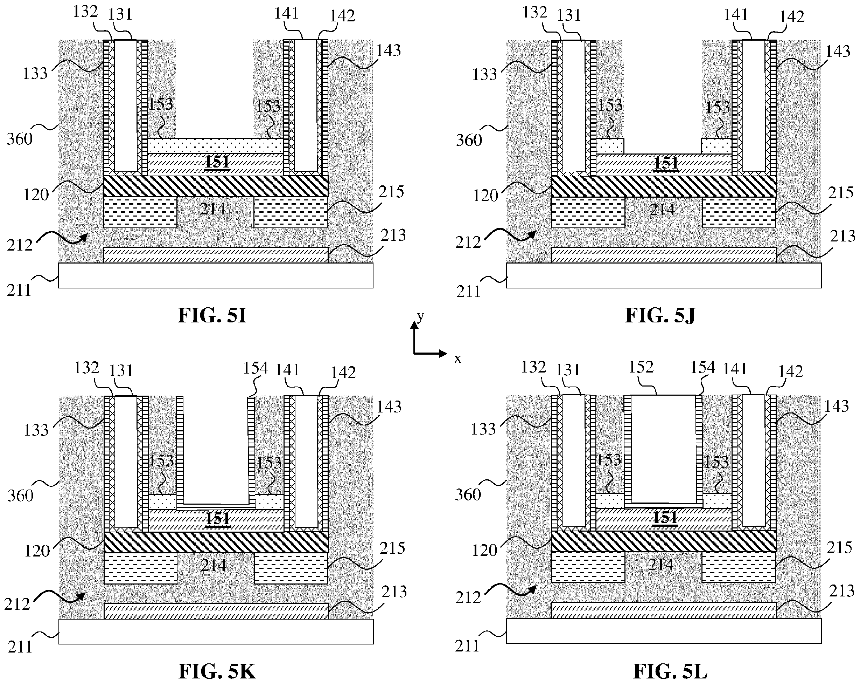

For example and not as a limitation, FIG. 5A to FIG. 5L show steps of a method for forming the transistor device 100 according to FIG. 3.

A step of forming a stack is depicted in FIG. 5A. The stack may comprise the substrate 211, the one or more base layers 212, exemplary the oxygen tunnel 212, the semiconductor (channel) layer 120, the dielectric layer 151 and the capping layer 153. Thus, the step of forming the stack may comprise providing the substrate 211, providing the oxygen tunnel 212, forming the semiconductor layer 120 on the one or more base layers, forming the dielectric layer 151 on the semiconductor layer 120, and forming a capping layer 153 on the dielectric layer 151, and covering said dielectric layer 151. Further, this step may also comprise a step of forming a third material layer 360 surrounding the stack.

Then, FIG. 5B to FIG. 5H depict the steps of forming the source and drain structures 130, 140. This may comprise the steps explained as follows.

First, the third material layer 360 on top of the capping layer 153 may be removed at two opposite sides (in the second or x-direction) of the stack, for example by wet or dry etching, exposing the capping layer 153 in said two opposite sides of the stack, as depicted in FIG. 5B.

Next, as shown in FIG. 5C, the capping layer 153 previously exposed may be further removed, e.g. by wet or dry etching, exposing the dielectric layer 151 below the capping layer at the two opposite sides (in the second or x-direction) of the stack.

Then, as shown in FIG. 5D, the dielectric layer 151 exposed in the previous step may be removed, for example by wet or dry etching. Thereby, the semiconductor layer 120, for example comprising a-IGZO, below the dielectric layer 151 may be exposed at the two opposite sides of the stack.

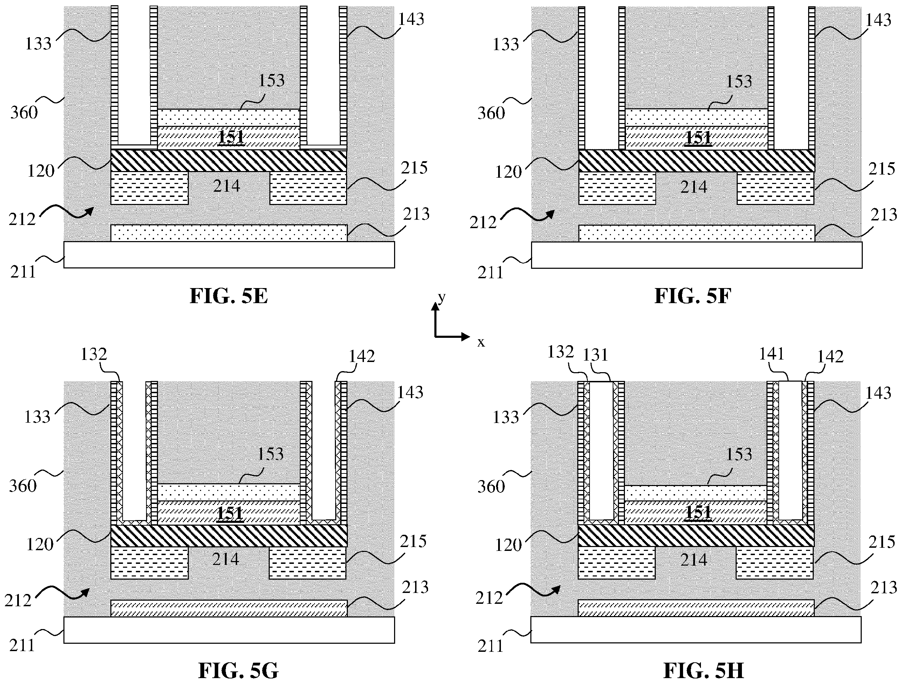

Therefrom, FIG. 5E depicts a step of depositing the second and third barrier layers 133, 143 into the recesses at the two opposite sides of the stack that were formed during the prior removal step.

The second and third barrier layers 133, 143 that were deposited on top of the semiconductor layer 120 may be subsequently removed, e.g., by wet or dry etching, exposing again the semiconductor layer 120 at the two opposite sides of the stack. This is depicted in FIG. 5F.

Next, as shown in FIG. 5G, the first material layer 132 and the second material layer 143 may be deposited into the recesses at the two opposite sides of the stack that were formed during the prior removal steps.

Further, the first metal electrode 131 maybe deposited into one of the recesses at one side of the stack, and the second metal electrode 141 maybe deposited into the other recess at the opposite side of the stack, as depicted in FIG. 5H. Thereby, the source and drain structures 130, 140 may be formed.

Therefrom, a step of forming the gate structure 150 may be performed, as depicted in FIG. 5I to FIG. 5L.

FIG. 5I shows that a central or substantially central portion of the capping layer 153 and being between the source and drain structures 130, 140 may be exposed by removing, for example by wet or dry etching, the third material layer 360 on top of it.

Subsequently, as depicted in FIG. 5J, a step of removing the central or substantially central part of the capping layer 153 exposed in the previous step may be performed by e.g. wet or dry etching. Thereby, the first and second portions of the capping layer 153 may be formed, the first portion being next to the source structure 130 and the second portion being next to the drain structure 140. At the same time, the dielectric layer 151 below the removed capping layer 153 may be exposed.

Then, a first material barrier 154 may be deposited into the recess formed in the previous step. This is depicted in FIG. 5J.

Next, FIG. 5K shows a step of depositing the gate metal electrode 152 into the recess formed in the previous steps.

The present disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A transistor device (100) comprising:
one or more base layers (110);
a semiconductor layer (120) arranged on the one or more base layers (110);
a source structure (130) arranged on the semiconductor layer (120);
a drain structure (140) arranged on the semiconductor layer (120); and
a gate structure (150) arranged on the semiconductor layer (120) between the source structure (130) and the drain structure (140), the gate structure (150) comprising:
- a dielectric layer (151) arranged on the semiconductor layer (120);
- a gate metal layer (152) arranged on the dielectric layer (151) to cover a portion of the dielectric layer (151); and
- a capping layer (153) comprising a first portion and a second portion, the first portion being arranged on the dielectric layer (151) between the source structure (130) and the gate metal layer (152), and the second portion being arranged on the dielectric layer (151) between the gate metal layer (152) and the drain structure (140);
wherein a height of the capping layer (153) and a height of the dielectric layer (151) are respectively smaller than a height of the gate metal layer (152).

2. The transistor device (100) according to claim 1, wherein the gate structure (150) further comprises a first barrier layer (154) provided on side surfaces of the gate metal layer (152) and between the gate metal layer (152) and the dielectric layer (151).

3. The transistor device (100) according to claims 1 or 2, wherein the semiconductor layer (120) comprises a metal oxide semiconductor, and wherein the metal oxide semiconductor comprises amorphous Indium-Gallium-Zinc-Oxide.

4. The transistor device (100) according to one of claims 1 to 3, wherein a height of the source structure (130) and a height of the drain structure (140) are respectively larger than a height of the semiconductor layer (120).

5. The transistor device (100) according to one of claims 1 to 4, wherein the source structure (130) comprises a first metal electrode (131) arranged on the semiconductor layer (120).

6. The transistor device (100) according to claim 5, wherein the source structure (130) further comprises a first material layer (132) provided on side surfaces of the first metal electrode (131) and between the first metal electrode (131) and the semiconductor layer (120).

7. The transistor device (100) according to claims 5 to 6, wherein the source structure (130) further comprises a second barrier layer (133) provided on side surfaces of the first material layer (132).

8. The transistor device (100) according to one of claims 1 to 7, wherein the drain structure (140) comprises a second metal electrode (141) arranged on the semiconductor layer (120).

9. The transistor device (100) according to one of claim 8, wherein the drain structure (140) further comprises a second material layer (142) provided on side surfaces of the second metal electrode (141) and between the second metal electrode (141) and the semiconductor layer (120).

10. The transistor device (100) according to claims 8 to 9, wherein the drain structure (140) further comprises a third barrier layer (143) provided on side surfaces of the second material layer (142).

11. The transistor device (100) according to one of claims 6, 7, 9 or 10, wherein the first material layer (132) comprises Indium-Tin-Oxide, ITO, and/or wherein the second material layer (142) comprises ITO.

12. The transistor device (100) according to one of claims 7 to 11, wherein the second barrier layer (133) comprises Titanium nitride, TiN, and/or wherein the third barrier layer (143) comprises TiN.

13. The transistor device (100) according to one of claims 2 to 12, wherein the first barrier layer (154) comprises TiN.

14. The transistor device (100) according to one of the claims 1 to 13, wherein the one or more base layers (110) comprise:
a substrate (211); and
one or more material layers (212) arranged above the substrate (211).

15. A method (400) for fabricating a transistor device (100), the method (400) comprising:
providing (401) one or more base layers;
forming (402) a semiconductor layer (120) on the one or more base layers;
forming (403) a source structure (130) on the semiconductor layer (120);
forming (404) a drain structure (140) on the semiconductor layer (120); and
forming (405) a gate structure (150) on the semiconductor layer (120) between the source structure (130) and the drain structure (140), wherein the gate structure (150) is formed by:
- forming (406) a dielectric layer (151) on the semiconductor layer (120);
- forming (407) a gate metal layer (152) on the dielectric layer (151) to cover a portion of the dielectric layer (151);
- forming (408) a capping layer (153) comprising a first portion and a second portion, the first portion being formed on the dielectric layer (151) between the source structure (130) and the gate metal layer (152), and the second portion being formed on the dielectric layer (151) between the gate metal layer (152) and the drain structure (140);
wherein a height of the capping layer (153) and a height of the dielectric layer (151) are respectively smaller than a height of the gate metal layer (152).

## Amended claims

### Amended claims in accordance with Rule 137(2) EPC.

1. A transistor device (100) comprising:
one or more base layers (110);
a semiconductor layer (120) arranged on the one or more base layers (110);
a source structure (130) arranged on the semiconductor layer (120);
a drain structure (140) arranged on the semiconductor layer (120); and
a gate structure (150) arranged on the semiconductor layer (120) between the source structure (130) and the drain structure (140), the gate structure (150) comprising:
- a dielectric layer (151) arranged on the semiconductor layer (120);
- a gate metal layer (152) arranged on the dielectric layer (151) to cover a portion of the dielectric layer (151); and
- a capping layer (153) comprising a first portion and a second portion, the first portion being arranged on the dielectric layer (151) between the source structure (130) and the gate metal layer (152), and the second portion being arranged on the dielectric layer (151) between the gate metal layer (152) and the drain structure (140),
wherein a height of the capping layer (153) and a height of the dielectric layer (151) are respectively smaller than a height of the gate metal layer (152); and
wherein the dielectric layer (151) and the capping layer (153) have each a planar shape structure that does not cover the side surfaces of the gate metal layer (152).

2. The transistor device (100) according to claim 1, wherein the gate structure (150) further comprises a first barrier layer (154) provided on side surfaces of the gate metal layer (152) and between the gate metal layer (152) and the dielectric layer (151).

3. The transistor device (100) according to claims 1 or 2, wherein the semiconductor layer (120) comprises a metal oxide semiconductor, and wherein the metal oxide semiconductor comprises amorphous Indium-Gallium-Zinc-Oxide.

4. The transistor device (100) according to one of claims 1 to 3, wherein a height of the source structure (130) and a height of the drain structure (140) are respectively larger than a height of the semiconductor layer (120).

5. The transistor device (100) according to one of claims 1 to 4, wherein the source structure (130) comprises a first metal electrode (131) arranged on the semiconductor layer (120).

6. The transistor device (100) according to claim 5, wherein the source structure (130) further comprises a first material layer (132) provided on side surfaces of the first metal electrode (131) and between the first metal electrode (131) and the semiconductor layer (120).

7. The transistor device (100) according to claims 5 to 6, wherein the source structure (130) further comprises a second barrier layer (133) provided on side surfaces of the first material layer (132).

8. The transistor device (100) according to one of claims 1 to 7, wherein the drain structure (140) comprises a second metal electrode (141) arranged on the semiconductor layer (120).

9. The transistor device (100) according to one of claim 8, wherein the drain structure (140) further comprises a second material layer (142) provided on side surfaces of the second metal electrode (141) and between the second metal electrode (141) and the semiconductor layer (120).

10. The transistor device (100) according to claims 8 to 9, wherein the drain structure (140) further comprises a third barrier layer (143) provided on side surfaces of the second material layer (142).

11. The transistor device (100) according to one of claims 6, 7, 9 or 10, wherein the first material layer (132) comprises Indium-Tin-Oxide, ITO, and/or wherein the second material layer (142) comprises ITO.

12. The transistor device (100) according to one of claims 7 to 11, wherein the second barrier layer (133) comprises Titanium nitride, TiN, and/or wherein the third barrier layer (143) comprises TiN.

13. The transistor device (100) according to one of claims 2 to 12, wherein the first barrier layer (154) comprises TiN.

14. The transistor device (100) according to one of the claims 1 to 13, wherein the one or more base layers (110) comprise:
a substrate (211); and
one or more material layers (212) arranged above the substrate (211).

15. A method (400) for fabricating a transistor device (100), the method (400) comprising:
providing (401) one or more base layers;
forming (402) a semiconductor layer (120) on the one or more base layers;
forming (403) a source structure (130) on the semiconductor layer (120);
forming (404) a drain structure (140) on the semiconductor layer (120); and
forming (405) a gate structure (150) on the semiconductor layer (120) between the source structure (130) and the drain structure (140), wherein the gate structure (150) is formed by:
- forming (406) a dielectric layer (151) on the semiconductor layer (120);
- forming (407) a gate metal layer (152) on the dielectric layer (151) to cover a portion of the dielectric layer (151);
- forming (408) a capping layer (153) comprising a first portion and a second portion, the first portion being formed on the dielectric layer (151) between the source structure (130) and the gate metal layer (152), and the second portion being formed on the dielectric layer (151) between the gate metal layer (152) and the drain structure (140);
wherein a height of the capping layer (153) and a height of the dielectric layer (151) are respectively smaller than a height of the gate metal layer (152); and
wherein the dielectric layer (151) and the capping layer (153) have each a planar shape structure that does not cover the side surfaces of the gate metal layer (152).
